Europäisches Patentamt

European Patent Office

Office européen des brevets

(11) Veröffentlichungsnummer: **0 442 358 A1**

## (12) EUROPÄISCHE PATENTANMELDUNG

(21) Anmeldenummer: 91101562.6

(22) Anmeldetag: 06.02.91

(51) Int. Cl.⁵: B29B 7/00, B29C 47/00,
G03F 7/033, C08J 3/12

(30) Priorität: 14.02.90 DE 4004510

(43) Veröffentlichungstag der Anmeldung:
21.08.91 Patentblatt 91/34

(84) Benannte Vertragsstaaten:
DE ES FR GB IT NL

(71) Anmelder: HOECHST AKTIENGESELLSCHAFT
Postfach 80 03 20
W-6230 Frankfurt am Main 80(DE)

(72) Erfinder: Schlosser, Hans Joachim, Dr.
Dipl.-Chem.
Am Rosengarten 2a
W-6200 Wiesbaden(DE)
Erfinder: Hildebrandt, Harry, Dipl.-Ing.
Kleiststrasse 14
W-6200 Wiesbaden(DE)
Erfinder: Schön, Günther
Friedrichstrasse 39
W-6200 Wiesbaden(DE)

(54) Verfahren zur Herstellung von Photopolymerplatten.

(57) Die Erfindung betrifft ein Verfahren zur Herstellung von Photopolymerplatten, bei dem ein photopolymerisierbares Gemisch, enthaltend ein thermoplastisch verarbeitbares, elastomeres Polymeres, eine einfach oder mehrfach ethylenisch ungesättigte Verbindung, die radikalisch polymerisierbar ist und einen Siedepunkt bei Normaldruck oberhalb 100 °C hat, sowie eine Verbindung oder Verbindungskombination, die unter Einwirkung von aktinischem Licht eine Polymerisation der ungesättigten Verbindungen einzuleiten vermag, in einen Schneckenextruder eindosiert, dort aufgeschmolzen und entgast und schließlich durch eine Breitschlitzdüse einem Kalanderspalt, in dem die Dickenausformung erfolgt, zugeführt wird, dadurch gekennzeichnet, daß man die Bestandteile des photopolymerisierbaren Gemisches vor der Zugabe in den Extruder vormischt, in dem man das in Granulatform vorliegende thermoplastische Polymere mit flüssigen Bestandteilen des Gemisches so lange kontaktiert bis diese vom Granulat absorbiert sind und anschließend das Granulat mit einem in den Flüssigkeiten nicht löslichen Pulver einer Korngröße von 0,005 bis 50 $\mu$m bestäubt.
Nach dem Verfahren werden optimal gemischte Produkte von einheitlicher Schichtdicke zugänglich.

Die Erfindung betrifft ein Verfahren zur Herstellung von Photopolymerplatten, insbesondere für den Flexodruck, bei dem ein photopolymerisierbares Gemisch, enthaltend ein thermoplastisch verarbeitbares, elastomeres Polymeres, eine einfach oder mehrfach ethylenisch ungesättigte Verbindung, die radikalisch polymerisierbar ist und einen Siedepunkt bei Normaldruck oberhalb 100 °C hat, sowie eine Verbindung oder Verbindungskombination, die unter Einwirkung von aktinischem Licht eine Polymerisation der ungesättigten Verbindungen einzuleiten vermag, in einen Schneckenextruder eindosiert, dort aufgeschmolzen und entgast und schließlich einem Kalanderspalt zugeführt wird.

Photopolymerplatten zur Herstellung von Reliefdruckplatten, insbesondere für den Flexodruck, die ein thermoplastisch verarbeitbares elastomeres Polymeres enthalten, sind bekannt. Sie werden insbesondere hergestellt, indem man ein Gemisch aus einem thermoplastisch verarbeitbaren elastomeren Polymeren, einer ethylenisch ungesättigten Verbindung, einem Photoinitiator und gegebenenfalls weiteren Zusatzstoffen in einem Walzen- oder Innenmischer aufschmilzt und diese Mischung anschließend durch Extrusion und Kalandrierung zu Platten ausformt (DE-A 21 38 582 = GB-A 1 358 062 und DE-A 22 15 090 = USA 4 423 135). Nachteilig ist bei diesem Verfahren, daß die Mischung zweimal thermisch belastet wird. Thermische Belastungen können zu Veränderungen der Bestandteile des Gemisches und einer nicht erwünschten vorzeitigen Vernetzung führen. Darüber hinaus ist bei den vorliegenden Verfahren eine genaue Dosierung des Gemisches, das stark verklebt, nur schwer möglich.

In der EP-A 0 080 665 wird ein Verfahren beschrieben, bei dem in einem selbstreinigenden Mehrschnekenextruder in einer ersten Zone die thermoplastisch verarbeitbaren Polymeren und weitere feste Zusatzstoffe eingeführt und in einer zweiten Zone, in der das thermoplastisch verarbeitbare Polymere aufgeschmolzen wird, die flüssigen Mischungsbestandteile zugegeben werden und danach die entgaste Schmelze zur Dickenausformung durch einen Kalanderspalt geführt wird. Nachteilig bei diesem Verfahren ist, daß verschiedene Dosiereinrichtungen für Feststoffe und Flüssigkeiten notwendig sind. Damit potenzieren sich die in der Zugabevorrichtung möglichen Dosierfehler. Rezepturschwankungen, die zu Schwankungen in der Viskosität der Schmelze und damit der Schichtdicke führen, sind die Folge. Darüber hinaus ist das Gemisch durch die große Länge des Extruders einer hohen thermischen Belastung ausgesetzt, u. a. auch einer außerordentlichen Scherbelastung.

Aufgabe der vorliegenden Erfindung ist es deshalb, ein Verfahren zu entwickeln, bei dem
- die Bestandteile des Gemisches möglichst geringen thermischen Belastungen ausgesetzt und damit produktschonend eingesetzt werden,
- die Bestandteile des Gemisches konstant dosierbar sind,
- sich keine Schwankungen in der Produktzusammensetzung ausbilden,
- die resultierende Photopolymerplatte eine konstante Schichtdicke aufweist.

Gelöst wird die Aufgabe durch ein Verfahren zur Herstellung von Photopolymerplatten, bei dem ein photopolymerisierbares Gemisch, enthaltend wenigstens ein thermoplastisch verarbeitbares, elastomeres Polymeres, wenigstens eine einfach oder mehrfach ethylenisch ungesättigte Verbindung, die radikalisch polymerisierbar ist und einen Siedepunkt bei Normaldruck oberhalb 100 °C hat, sowie wenigstens eine Verbindung oder Verbindungskombination, die unter Einwirkung von aktinischem Licht eine Polymerisation der ungesättigten Verbindungen einzuleiten vermag, in einen Schneckenextruder eindosiert, dort aufgeschmolzen und entgast und schließlich durch eine Breitschlitzdüse einem Kalanderspalt, in dem die Dickenausformung erfolgt, zugeführt wird, dadurch gekennzeichnet, daß man die Bestandteile des photopolymerisierbaren Gemisches vor der Zugabe in den Extruder vormischt, indem man das in Granulatform vorliegende thermoplastische Polymere mit flüssigen Bestandteilen des Gemisches so lange kontaktiert bis diese vom Granulat absorbiert sind und anschließend das Granulat mit einem in den Flüssigkeiten nicht löslichen Pulver einer mittleren Korngröße von 0,005 bis 50 $\mu$m bestäubt.

Insbesondere werden solche Pulver verwendet, die eine mittlere Korngröße von 0,005 bis 10 $\mu$m aufweisen. Die Bestimmung der Korngröße kann z. B. durch mikroskopische Untersuchungen erfolgen. Als besonders geeignetes Pulver kommt pyrogene hochdisperse Kieselsäure in Frage. Gegebenenfalls kann die Kieselsäure durch Oberflächenmodifizierung hydrophobiert sein. Hierbei wird Kieselsäure mit Organosilanen umgesetzt. Bevorzugt wird die Oberfläche der Kieselsäureteilchen hydrophobiert.

Der Grad der Hydrophobierung wird als Gehalt an Kohlenstoff in der Kieselsäure bestimmt. Er beträgt weniger als 5 Gew.-%, insbesondere weniger als 3 Gew.-%. Die Oberfläche nach BET der geeigneten Kieselsäure beträgt 50 bis 250 m$^2$/g, insbesondere 120 bis 200 m$^2$/g.

Weitere geeignete pulverige Substanzen sind Talkum, Diatomenerde, Titandioxid, Calciumcarbonat, Magnesiumcarbonat, Aluminiumsilikat sowie acrylische, ultrafeine Pulver. Unter acrylischen Pulvern versteht man insbesondere die der Methacrylate, vorzugsweise Polymethyl- bzw. Polybutyl-methacrylate.

Der Gehalt an dem erfindungsgemäß verwendeten Pulver liegt im allgemeinen bei 0,05 bis 5 Gew.-%, insbesondere bei 0,1 bis 3 Gew.-%, bezogen auf die festen Bestandteile des photopolymerisierbaren

EP 0 442 358 A1

Gemisches.

Durch die Bestäubung mit dem Pulver wird ein gut dosierbares, nicht klebriges und damit rieselfähiges Produkt erhalten. Eine separate Zumischung der Flüssigkeiten in den Extruder kann daher unterbleiben. Besonders überraschend dabei war, daß das vorgemischte, im Granulat enthaltene gesamte Reaktionsgemisch über Wochen haltbar war und seine Rieselfähigkeit behielt.

Ein weiterer Vorteil des erfindungsgemäßen Verfahrens liegt darin, daß der Extruder kürzer sein und damit die thermische Belastung der Bestandteile begrenzt werden kann.

Zum Einmischen der flüssigen Bestandteile in das Polymergranulat sind alle Mischer geeignet, die das Produkt schonend behandeln und zu einer möglichst geringen Erwärmung des Produkts führen. Geeignete Mischer sind beispielsweise Pflugschar-, Bandschnecken-, Paddel-, Trommel- oder Freifallmischer. Sind die einzumischenden Flüssigkeiten nicht miteinander mischbar, können sie nacheinander eingegeben werden. Nach der Einmischung der Flüssigkomponenten muß die Mischung vorsichtig im Mischer bewegt werden, um ein Zusammenballen zu verhindern. Die hierfür notwendige Zeit ist durch die Eindiffusion der Flüssigkeit in die Polymeren bedingt. Sie ist von Polymer und Korngröße des Polymergranulats abhängig und leicht zu ermitteln. Eine Einwirkzeit von 60 min ist zumeist ausreichend.

Wenn die Leistungsaufnahme des Mischers nach anfänglichem Anstieg wieder auf einen konstanten Wert abgefallen ist, kann mit der Zugabe des Pulvers begonnen werden. Die Einwirkzeit des Pulvers auf das Granulat hängt von den Korngrößen des Granulats und des Pulvers ab. Im allgemeinen sind Zeiten in der Größenordnung von Minuten, insbesondere 1 bis 10 min, hinreichend.

Das in der beschriebenen Weise vorgemischte, rieselfähige, nicht klebrige Granulat wird in einen dem Fachmann bekannten Extruder eingebracht. Es können Ein- oder auch selbstreinigende Zweischneckenextruder verwendet werden. Zweischneckenextruder sind dann besonders vorteilhaft, wenn dem Granulat zusätzlich ein weiterer Feststoff zugegeben werden soll. Ebenso ist es vorstellbar, einen Teil der Flüssigkeit nicht dem Granulat beizumischen, sondern dem Extruder separat einzuspeisen. Auch in diesem Fall ist ein Zweischneckenextruder vorzuziehen.

Das rieselfähige Granulat wird in die erste, zumeist nicht geheizte Zone des Extruders eingeführt. Die - vorzugsweise vier - folgenden Zonen sind auf Temperaturen von 130 bis 220 °C, insbesondere 130 bis 170 °C, geheizt. Eine weitere Zone wird als Entgasungszone benutzt. Sie ist insbesondere auf 60 bis 140 °C geheizt. Die Gesamtlänge des Extruders beträgt vorwiegend das 10- bis 90fache seines Durchmessers.

Nachdem die Schmelze gegebenenfalls nach Anlegen eines Vakuums entgast worden ist, wird sie auf eine temperierbare Breitschlitzdüse mit separat beheizbaren Düsenlippen aufgetragen. Die Öffnung der Düsenlippen ist jeweils auf die gewünschte Dicke der extrudierten Platte abzustimmen. Insbesondere ist der Lippenspalt 3 bis 20 mm dick.

Die äußeren Abmessungen der Düse sind derart gestaltet, daß die die Düse verlassende Schmelze auf dem kürzesten Weg in den Spalt eines Zweiwalzenkalanders geführt wird. Im Walzenspalt wird die Photopolymermischung auf die gewünschte Dicke ausgeformt. Zwangsläufig bildet sich dabei ein Wulst der Photopolymerschicht zwischen den Kalanderwalzen aus. Durch geeignete prozeßtechnische Steuerung des Ablaufs soll der Wulst möglichst klein gehalten werden. Die Walzen können von mitlaufenden Folien umschlungen sein, die kontinuierlich mit in den Walzenspalt einlaufen. Die Folien können aus Kunststoff oder Metall und eventuell vorbeschichtet sein, z. B. mit einem Haftvermittler.

Das photopolymerisierbare Gemisch ist zwischen den Kalanderwalzen noch thermoplastisch umformbar. Die Temperatur der Walzen ist separat einstellbar. Die den Kalanderspalt verlassende Photopolymerplatte, die gegebenenfalls ein Mehrschichtenlaminat darstellt, wird vorzugsweise auf ein mitlaufendes Band, z. B. ein perforiertes Stahlband (wobei ein Vakuumkasten dafür sorgt, daß die Photopolymerplatte an das Band gezogen wird oder bei einem Laminat die Schichten des Laminats aufeinander fixiert werden), gegeben und kann dann nach hinreichender Abkühlung entweder aufgewickelt oder zum gewünschten Format, z. B. mit einem Querschneider, konfektioniert werden. Der Abtransport kann auch durch Walzenabzug erfolgen. Ebenso kann nach dem Verlassen des Kalanderspalts oder dem Abkühlen die Photopolymerplatte bzw. das Mehrschichtenlaminat in der üblichen Weise an den Rändern beschnitten werden.

Wenn es gewünscht wird, kann die Platte nach dem Verlassen des Kalanderspalts teilvernetzt werden, indem man sie von einer Seite vollflächig mit aktinischem Licht bestrahlt, so daß der vernetzte Teil der Schicht gleichzeitig als Träger des noch nicht vernetzten Bereiches der Schicht dient.

Zur Bildaufzeichnung können die lichtempfindlichen Platten in bekannter Weise mit aktinischem Licht bildmäßig belichtet und die unbelichteten Schichtteile mit einem Entwickler entfernt werden.

Die lichtempfindlichen Schichten bzw. Laminate eignen sich zur Herstellung von Reliefformen und Reliefdruckplatten, zur Beschichtung von Walzen, zur Herstellung von Endlosbändern, Unterlagen z. B. für Druckplatten, Trägerschichten, Verpackungsmaterialien etc.

Die nach dem erfindungsgemäßen Verfahren hergestellten Platten weisen eine hohe Homogenität der

3

Verteilung der Bestandteile in der Schicht bei einer erheblich hohen Dickenkonstanz auf. Die Homogenität der Verteilung der Bestandteile in der Platte wird mit Hilfe des sogenannten Variationskoeffizienten beurteilt, der sich bei optischen Dichtemessungen über die Breite der Platte ergibt. Das erfindungsgemäße Verfahren zeichnet sich dadurch aus, daß die optische Dichte der Platten insbesondere einen Variationskoeffizienten von kleiner als 0,02, insbesondere von kleiner als 0,015 und vorzugsweise von kleiner als 0,010, aufweisen.

Der Variationskoeffizient ist ein Maß für die relative Streuungsbreite und wird als Funktion der Varianz $\sigma$ und des Mittelwertes $\mu$ gemäß

$$\sqrt{\frac{\sigma^2}{\mu}}$$

bestimmt.

Die in dem erfindungsgemäßen Verfahren eingesetzten photopolymerisierbaren Gemische enthalten als thermoplastisch verarbeitbare elastomere Polymere: Naturkautschuke, Homopolymerisate von Butadien und Isopren, Copolymerisate von Butadien mit Isopren, Copolymerisate von Butadien und/oder Isopren mit anderen Monomeren wie Styrol, Vinyltoluol, Acrylnitril oder (Meth-)Acrylsäurealkylester, z. B. Nitrilkautschuke, statistische Styrol/Butadien-, Styrol/Isopren- und Styrol/Isopren/Butadien-Copolymerisate oder Blockcopolymerisate aus Styrolmonomeren und Butadien und/oder Isopren mit einem Styrolgehalt von 10 bis 50 Gew.-%. Die Verwendung solcher Elastomeren ist beispielsweise in den DE-A 21 38 582, 22 15 090, 24 56 439 und 29 42 183 beschrieben. Geeignet sind auch Polymere auf der Basis von Polyurethanen und Polyvinylalkohol aus der DE-A 38 24 146 und Polyamiden. Die durch Photopolymerisation vernetzbaren Schichten enthalten im allgemeinen 20 bis 98 Gew.-%, vorzugsweise 30 bis 95 Gew.-%, des elastomeren Polymeren. Die elastomeren Polymeren werden im erfindungsgemäßen Verfahren in Granulatform eingesetzt.

Auf diese als Granulat vorliegenden elastomeren Polymeren läßt man folgende Flüssigkeiten nach dem erfindungsgemäßen Verfahren einwirken:

Zu der Klasse der einfach oder mehrfach ungesättigten Verbindungen, die radikalisch polymerisierbar sind und einen Siedepunkt oberhalb von 100 °C aufweisen, zählen insbesondere Ester und Amide von Acryl- und Methacrylsäure. Beispiele sind die verträglichen Mono- und Diacrylate und -methacrylate von ein- oder mehrwertigen Alkoholen wie Ethylenglykol, Di-, Tri-, Tetra- oder Polyethylenglykolen, letztere bevorzugt mit 10 bis 15 Ethylenglykoleinheiten, 1,3-Propandiol, 1,6-Hexandiol, Dodecandiol, Tetradecandiol, 1,1,1-Trimethylolpropan, 1,2,4-Butantriol oder Pentaerythrit, z. B. Ethylenglykolmonomethacrylat, 1,3-Propandiolmonomethacrylat, Glycerinmono- und -diacrylat, Hexandioldiacrylat, Hexandioldimethacrylat, 2-Ethylhexylacrylat, Laurylmethacrylat, Stearylmethacrylat, 1,2,3-Butantriolmonomethacrylat, Pentaerythrittriacrylat, Polyethylenglycolmethyletheracrylat, Tetradecaethylenglycolmethacrylat, Tetradecaethylenglykoldimethacrylat oder der Triether aus Glycerin und 3 mol N-Methylolacrylamid oder -methacrylamid.

Ebenso sind Alkenylphosphonsäuren und deren Ester nach der DE-A 38 17 424 anwendbar. Geeignet sind auch Fumarsäureester aus der US-A 4 197 130 und der deutschen Patentanmeldung P 40 01 465.7.

Es können auch Mischungen aus den verschiedenen Monomeren verwendet werden. Die Menge an den ungesättigten Verbindungen liegt im allgemeinen bei 1 bis 70 Gew.-%, bevorzugt bei 2 bis 50 Gew.-%, bezogen auf die nichtflüchtigen Bestandteile des Gemisches.

Als Photoinitiatoren werden im photopolymerisierbaren Gemisch solche bekannten Verbindungen verwendet, die eine hinreichend thermische Stabilität bei der Verarbeitung der Aufzeichnungsmaterialien sowie eine ausreichende Radikalbildung bei Belichtung unter Initiierung der Polymerisation der Monomeren aufweisen. Sie sollen Licht im Wellenlängenbereich von ca. 250 bis ca. 500 nm unter Bildung von Radikalen absorbieren. Beispiele geeigneter Photoinitiatoren sind Acyloine und deren Derivate wie Benzoin, Benzoinalkylether, z. B. Benzoinisopropylether, vicinale Diketone und deren Derivate, z.B. Benzil, Benzilacetale wie Benzildimethylketal, Fluorenone, Thioxanthone, Mehrkernchinone, Acridine und Chinoxaline; ferner Trichlormethyl-s-triazine, 2-Halogenmethyl-4-vinyl-1,3,4-oxadiazolderivate, mit Trichlormethylgruppen substituierte Halogenoxazole, Trihalogenmethylgruppen enthaltende Carbonylmethylenheterocyclen gemäß DE-A 33 33 450, Acylphosphinoxidverbindungen, wie sie z. B. in der DE-A 31 33 419 beschrieben sind, und andere phosphorhaltige Photoinitiatoren, z. B. die in der DE-A 37 28 168 beschriebenen 6-Acyl-6H-dibenzo-[c,e][1,2]oxaphosphorin-6-oxide, insbesondere das 6-(2,4,6-Trimethylbenzoyl)-6H-dibenzo[c,e][1,2]-oxaphosphorin-6-oxid. Die Photoinitiatoren lassen sich auch in Kombination miteinander oder mit Coinitiatoren bzw. Aktivatoren verwenden, z.B. mit Michlers Keton und seinen Derivaten oder 2-Alkylanthrachinonen.

Die Menge an Photoinitiator beträgt im allgemeinen etwa 0,01 bis 10 Gew.-%, bevorzugt etwa 0,5 bis 5 Gew.-% des photopolymerisierbaren Gemisches.

Oft ist es von Vorteil, dem photopolymerisierbaren Gemisch noch weitere Hilfs- und Zusatzstoffe zuzugeben, z. B. Inhibitoren der thermischen Polymerisation wie Hydrochinon und seine Derivate, 2,6-Di-tert.-butyl-p-kresol, Nitrophenole, Nitrosamine wie N-Nitrosodiphenylamin oder Salze des N-Nitrosocyclohexylhydroxylamins, z. B. dessen Alkali- oder Aluminiumsalze. Weitere übliche Zusätze sind Farbstoffe, Pigmente, Lichthofschutzmittel, Antiozonantien, wie beispielsweise mikrokristallines Wachs oder Paraffinwachs, Vernetzungsmittel, Regler, Füllmittel, Fließmittel und Weichmacher.

Die folgenden Beispiele beschreiben die besondere Anwendung des erfindungsgemäßen Verfahrens. In den Beispielen stehen Vt für Volumenteile und Gt für Gewichtsteile, wobei sich g : cm$^2$ wie 1 : 1 verhalten. Die Prozentangaben beziehen sich, sofern nichts anderes angegeben ist, auf Gewichtsprozente.

## Vergleichsbeispiel V1

In einem VM Mischer 140 S der Firma Lescha mit einem Volumen von 140 l werden bei einer Drehzahl von 24 U/min 10.000 Gt eines Dreiblockcopolymeren des Typs Styrollsopren-Styrol (Styrolgehalt: 15 Gew.-%) in Granulatform vorgelegt. Anschließend wird eine Lösung, bestehend aus

| | |
|---|---|
| 488 | Gt Hexandioldiacrylat, |
| 244 | Gt Hexandiolmethacrylat, |
| 60 | Gt 2,6-Di-tert.-butyl-4-methylphenol, |
| 245 | Gt Benzildimethylketal und |
| 1,22 | Gt Solvent Black 3 |

innerhalb von 3 Minuten zudosiert und danach innerhalb von 2 Minuten eine 60 °C warme Mischung aus

| | |
|---|---|
| 122 Gt | eines mikrokristallinen Wachses (Schmelzbereich bis 60 °C) und |
| 232 Gt | eines paraffinischen Öls (kinematische Viskosität bei 20 °C 250/mm$^2$) |

zugegeben und 60 Minuten lang gemischt. Man erhält ein nicht dosierfähiges, klebriges Agglomerat, das auch durch Änderung der Mischzeit nicht verbessert werden kann.

## Vergleichsbeispiel V2

Es wird wie in Vergleichsbeispiel V1 vorgegangen. Nach der Dosierung der Flüssigkeiten wird allerdings sofort hydrophobierte hochdisperse Kieselsäure (Oberfläche nach BET: 120 m$^2$/g) zugesetzt. Anschließend wird 60 Minuten lang gemischt. Unabhängig von der Dauer der Mischzeit erhält man ein nicht dosierfähiges, klebriges Agglomerat.

## Vergleichsbeispiel V3

In einem Pflugscharmischer der Firma Lödige mit einem Volumen von 5 l werden bei einer Drehzahl von 110 U/min 800 Gt eines Dreiblockcopolymeren des Typs Styrollsopren-Styrol (Styrolgehalt: 15 Gew.-%) in Granulatform vorgelegt. Anschließend wird eine Lösung, bestehend aus

| | |
|---|---|
| 39 | Gt Hexandioldiacrylat, |
| 19,5 | Gt Hexandiolmethacrylat, |
| 5 | Gt 2,6-Di-tert.-butyl-4-methylphenol, |
| 19,36 | Gt Benzildimethylketal und |
| 0,22 | Gt Solvent Black 3 |

innerhalb von 3 Minuten zudosiert und danach innerhalb von 2 Minuten eine auf 60 °C temperierte Mischung aus

| | |
|---|---|
| 9,79 Gt | eines mikrokristallinen Wachses (wie V1) und |
| 58,5 Gt | eines paraffinischen Öls (kinematische Viskosität bei 20 °C 250/mm$^2$) |

zugegeben.

Auch bei Anwendung unterschiedlicher Mischzeiten erhält man ein nicht dosierfähiges, klebriges Agglomerat.

## Vergleichsbeispiel V4

Es wird wie in Vergleichsbeispiel V3 vorgegangen, mit dem Unterschied, daß die Flüssigkeit innerhalb von 5 (statt 2) Minuten zugegeben wird.

Es ändert sich nichts an den bisherigen Ergebnissen.

Vergleichsbeispiel V5

Mit einer Differentialdosierwaage (K-tron Soder LWF-3) wird ein Dreiblockcopolymeres des Typs Styrollsopren-Styrol (Styrolgehalt: 15 Gew.-%) in Granulatform in die kalte Einzugszone eines Zweischnek-kenextruders kontinuierlich zugegeben. Der Schneckendurchmesser des Extruders beträgt 96 mm und die Gesamtlänge der Schnecke das 28fache des Durchmessers. Die vier folgenden Zonen des Extruders werden jeweils auf 130 °C geheizt. Am Ende der ersten Heizzone wird eine Lösung der flüssigen Bestandteile mit einer Flüssigkeitspumpe zugeführt. Eine der untersuchten Lösungen enthält die Bestandteile in den Gewichtsverhältnissen des Vergleichsbeispiels V3. Die letzte (6. Zone) ist eine Entgasungszone, in der mit einer Vakuumpumpe flüchtige Bestandteile abgesaugt werden. Nach einem Filter, in Produktfließrichtung gesehen, befindet sich im Anschluß an den Extruder eine Schmelzepumpe, die einen konstanten Austrag der Schmelze durch eine darauf folgende 20 mm dicke, 450 mm breite, temperierte Breitschlitzdüse ermöglicht. Die aus dieser Düse austretende Schmelze wird direkt Schmelze wird direkt zwischen die Walzen eines Kalanders geführt. In diesen Spalt mit einer Dicke von 3 mm werden außerdem Polyesterfo-lien mit je 125 μm Dicke von oben und von unten eingeführt. Um das Ausmaß und die Güte der Homogenisierung zu bestimmen, wird die optische Dichte über die jeweilige Breite der laminierten Platte in jeweiligen Abständen von 1 cm bei einer Wellenlänge von 600 nm, die dem Absorptionsmaximum des zugesetzten Farbstoffs entspricht, bestimmt. Ein Maß für die Güte der Homogenisierung ist der sogenannte Variationskoeffizient der gemessenen optischen Dichte über die Breite. Er beträgt 0,022.

Beispiel 1

Es wird eine Mischung gemäß Vergleichsbeispiel V1 hergestellt. Nach der angegebenen Mischzeit von 60 Minuten werden innerhalb von 2 Minuten 50 Gt hydrophobierte hochdisperse Kieselsäure (Oberfläche nach BET: 120 m²/g) eingemischt. Es wird ein rieselfähiges, gut dosierbares Granulat erhalten.

Nach einer Woche Lagerung wird dieses Granulat mit einer Differentialdosierwaage (K-tron Soder LWF-3) in die kalte Einzugszone eines Zweischneckenextruders kontinuierlich zugegeben. Der Schneckendurchmesser des Extruders beträgt 90 mm, die Gesamtlänge der Schnecke das 28fache des Durchmessers. Die vier folgenden Zonen des Extruders werden jeweils auf 130 °C geheizt. Die nächste Zone entspricht einer Entgasungszone, in der mit einer Vakuumpumpe flüchtige Bestandteile abgesaugt werden. Die Schmelze wird anschließend durch einen Filter in eine Schmelzepumpe geleitet, die einen konstanten Austrag der Schmelze durch eine darauf folgende 20 mm dicke, 450 mm breite, temperierte Breitschlitzdüse ermöglicht. Die aus dieser Düse austretende Schmelze wird direkt zwischen die Walzen eines Kalanders geführt. In diesen Spalt mit einer Dicke von 3 mm werden außerdem Polyesterfolien von je 125 μm Dicke von oben und von unten eingeführt.

Man erhält Platten hoher Dickengenauigkeit mit sehr homogener Zusammensetzung. Der Variationskoeffizient beträgt 0,008. Die Platte ist deutlich homogener als die Probe aus dem Vergleichsbeispiel V5.

Beispiel 2

Aus einer Mischung gemäß Vergleichsbeispiel V3 wird ein Granulat wie in Beispiel 1 beschrieben hergestellt.

Nach 48 Stunden Lagerung wird dieses Granulat mit einem Schneckendosierer der Firma Gericke in die kalte Einzugszone eines Zweischneckenextruders eingefüttert. Der Schneckendurchmesser des Extruders beträgt 34 mm, die Gesamtlänge der Schnecke das 23fache des Durchmessers. Die vier folgenden Zonen des Extruders werden jeweils auf 140 °C geheizt. Die sechste Zone entspricht einer Entgasungszone, in der mit einer Vakuumpumpe flüchtige Bestandteile abgesaugt werden. Die Schmelze tritt aus einer 5 mm breiten und 75 mm langen Breitschlitzdüse aus und wird sofort mit Hilfe eines Walzenpaares beidseitig mit Polyesterfolie laminiert (Spaltenbreite der Düse je nach gewünschter Plattenstärke 1 bis 5 mm). Das so hergestellte Laminat aus lichtempfindlicher Platte und zwei diese begrenzende Polyesterfolien wird durch zwei Abzugswalzen weggeführt. Die Laminate weisen eine gute Homogenität auf.

Beispiele 3 bis 6

Es wird wie in Beispiel 2 vorgegangen. Anstelle der dort verwendeten hydrophobierten hochdispersen Kieselsäure werden die in Tabelle I aufgeführten Produkte benutzt. Geprüft wird die Rieselfähigkeit des Laminats im Verhalten in einer Vibrationsrinne. Außerdem wird das Gemisch 72 Stunden mit einem Druck von 3·10³ N/m² belastet und der Rühraufwand zum Wiederherstellen des dosierfähigen Granulats beurteilt.

## Tabelle I

| Bei-spiele | Stoffe | Menge in Gew.-% | Riesel-fähig-keit | Wieder-aufrühr-barkeit |
|---|---|---|---|---|
| 3 | stark hydropho-bierte Kieselsäure (BET: 130 m²/g) | 0,5 | sehr gut | auf-rühr-bar |
| 4 | nicht hydropho-bierte Kieselsäure (BET: 200 m²/g) | 0,5 | sehr gut | leicht aufrühr-bar |
| 5 | Talkum | 2 | gut | aufrühr-bar |
| 6 | Polymethylmeth-acrylat (Korn-größe: 0,4 µm) | 0,5 | gut | auf-rühr-bar |

Beispiel 7

1,41 Gt eines Pfropfpolymeren (Pfropfgrundlage: Polyurethan aus Polyethylenglykol 600 und Isophoronisocyanat, gepfropft mit Vinylacetat und anschließend verseift; siehe DE-A 38 24 146) werden mit 141,4 Gt 2-Hydroxyethylacrylat und 9 Gt Pentaerythrittriacrylat mit einem Ankerrührer gemischt. Nach einer Quellzeit von 60 Minuten werden unter Rühren 2,18 Gt hydrophobierte hochdisperse Kieselsäure aus Beispiel 1 zugegeben. Nach zweiminütigem Rühren erhält man ein ausgezeichnetes rieselfähiges Granulat.

**Patentansprüche**

1. Verfahren zur Herstellung von Photopolymerplatten, bei dem ein photopolymerisierbares Gemisch, enthaltend wenigstens ein thermoplastisch verarbeitbares, elastomeres Polymeres, wenigstens eine einfach oder mehrfach ethylenisch ungesättigte Verbindung, die radikalisch polymerisierbar ist und einen Siedepunkt bei Normaldruck oberhalb 100 °C hat, sowie wenigstens eine Verbindung oder Verbindungskombination, die unter Einwirkung von aktinischem Licht eine Polymerisation der ungesättigten Verbindungen einzuleiten vermag, in einen Schneckenextruder eindosiert, dort aufgeschmolzen und entgast und schließlich durch eine Breitschlitzdüse einem Kalanderspalt, in dem die Dickenausformung erfolgt, zugeführt wird, dadurch gekennzeichnet, daß man die Bestandteile des photopolymerisierbaren Gemisches vor der Zugabe in den Extruder vormischt, indem man das in Granulatform vorliegende thermoplastische Polymere mit flüssigen Bestandteilen des Gemisches so lange kontaktiert bis diese vom Granulat absorbiert sind und anschließend das Granulat mit einem in den Flüssigkeiten nicht löslichen Pulver einer Korngröße von 0,005 bis 50 µm bestäubt.

2. Verfahren nach Anspruch 1, dadurch gekennzeichnet, daß eine Korngröße des Pulvers von 0,005 bis 10 µm reicht.

3. Verfahren nach einem der Ansprüche 1 bis 2, dadurch gekennzeichnet, daß als Pulver pyrogene, hochdisperse Kieselsäure, Talkum, Diatomenerde, Titandioxid, Calciumcarbonat, Magnesiumcarbonat oder Aluminiumsilikat sowie acrylische, ultrafeine Pulver verwendet werden.

4. Verfahren nach Anspruch 3, dadurch gekennzeichnet, daß hydrophobierte, pyrogene, hochdisperse Kieselsäure als Pulver verwendet wird.

5. Verfahren nach einem der Ansprüche 3 und 4, dadurch gekennzeichnet, daß die Oberfläche nach BET der pyrogenen Kieselsäure 50 bis 250 $m^2$/g, insbesondere 120 bis 200 $m^2$/g, beträgt.

6. Verfahren nach einem der Ansprüche 1 bis 5, dadurch gekennzeichnet, daß das Pulver in einer Konzentration von 0,05 bis 5 Gew.-%, insbesondere von 0,1 bis 3 Gew.-%, bezogen auf die festen Bestandteile des photopolymerisierbaren Gemisches, enthalten ist.

7. Verfahren nach einem der Ansprüche 1 bis 6, dadurch gekennzeichnet, daß die Mischung nach dem Behandeln des Granulats mit der Flüssigkeit so lange im Mischer bewegt wird, bis die Flüssigkeit in das Granulat eindiffundiert ist.

8. Verfahren nach Anspruch 7, dadurch gekennzeichnet, daß das Granulat nach dem Behandeln mit der Flüssigkeit ca. 60 min weiterbewegt wird, bevor man das Pulver der Mischung zusetzt.

9. Verfahren nach einem der Ansprüche 1 bis 8, dadurch gekennzeichnet, daß die Einwirkzeit des Pulvers auf das Granulat 1 bis 10 min beträgt.

10. Verfahren nach einem der Ansprüche 1 bis 9, dadurch gekennzeichnet, daß das rieselfähige Granulat in einem Pflugschar-, Bandschnecken-, Paddel-, Trommel- oder Freifallmischer hergestellt wird.

11. Verfahren nach einem der Ansprüche 1 bis 10, dadurch gekennzeichnet, daß das rieselfähige Granulat in die nicht geheizte Zone des Extruders, insbesondere des Zweischneckenextruder, eingespeist wird.

12. Verfahren nach einem der Ansprüche 1 bis 11, dadurch gekennzeichnet, daß die Kalanderwalzen von mitlaufenden Folien umschlungen sind, die die Breitschlitzdüse verlassende Photopolymerplatte abdekken.

13. Verwendung der nach den Ansprüchen 1 bis 12 hergestellten Polymerplatte zur Herstellung von Reliefformen, Reliefdruckplatten, Endlosbändern, Unterlagen etc. und zur Beschichtung von Walzen.

Europäisches
Patentamt

**EUROPÄISCHER RECHERCHENBERICHT**

Nummer der Anmeldung

**EP 91 10 1562**

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y,D | EP-A-0 080 665 (BASF AG)<br>* Ansprüche 1,8 *<br><br>– – – | 1-13 | B 29 B 7/00<br>B 29 C 47/00<br>G 03 F 7/033<br>C 08 J 3/12 |
| Y | FR-A-2 316 064 (BAYER AG et al.)<br>* Anspruch 1 *<br><br>– – – | 1-13 | |
| Y | US-A-3 661 810 (H. GAHMIG)<br>* Spalte 2, Zeilen 3-8,24-34 *<br><br>– – – | 1-13 | |
| A | RESEARCH DISCLOSURE, Nr. 218, Juni 1982, Seite 195, Spalte 1, Nr. 21803, Havant, Hampshire, GB; "Free-flowing polyester particles"<br><br>– – – – – | | |

| RECHERCHIERTE SACHGEBIETE (Int. Cl.5) |
|---|
| B 29 B<br>B 29 C<br>C 08 J |

Der vorliegende Recherchenbericht wurde für alle Patentansprüche erstellt

| Recherchenort | Abschlußdatum der Recherche | Prüfer |
|---|---|---|
| Den Haag | 21 Mai 91 | VAN NIEUWENHUIZE O. |